# EUROPÄISCHE PATENTSCHRIFT

(11) **EP 3 426 599 B1**
(45) Veröffentlichungstag und Bekanntmachung des Hinweises auf die Patenterteilung: **23.04.2025**
(21) Anmeldenummer: 17706806.1
(22) Anmeldetag: 23.02.2017
(51) Int. Cl.: C01B 13/11

(54) **VERFAHREN ZUR HERSTELLUNG VON OZON UND VORRICHTUNG ZUR OZONGENERIERUNG**
PROCESS FOR PRODUCING OZONE AND APPARATUS FOR OZONE GENERATION
PROCÉDÉ DE GÉNÉRATION D'OZONE ET DISPOSITIF DE GÉNÉRATION D'OZONE

(30) Priorität: 07.03.2016 DE 102016104104
(43) Veröffentlichungstag der Anmeldung: 16.01.2019
(73) Patentinhaber: TDK Electronics AG, 81671 München (DE)
(72) Erfinder: WEILGUNI, Michael, 4232 Hagenberg (AT); PUFF, Markus, 8010 Graz (AT); KUDELA, Pavol, 8530 Deutschlandsberg (AT)
(74) Vertreter: Epping - Hermann - Fischer
(86) Internationale Anmeldenummer: PCT/EP2017/054219
(87) Internationale Veröffentlichungsnummer: WO 2017/153179

(56) Entgegenhaltungen:
- WO-A1-2016/012282
- CN-Y- 2 638 482
- JP-A- 2003 257 589
- JP-A- 2009 035 468
- ITOH H ET AL: "Discharge plasmas generated by piezoelectric transformers and their applications; Discharge plasmas generated by piezoelectric transformers", PLASMA SOURCES SCIENCE AND TECHNOLOGY, INSTITUTE OF PHYSICS PUBLISHING, BRISTOL, GB, vol. 15, no. 2, 1 May 2006 (2006-05-01), pages S51 - S61, XP020105199, ISSN: 0963-0252, DOI: 10.1088/0963-0252/15/2/S07

## Beschreibung

Die vorliegende Erfindung betrifft ein Verfahren zur Herstellung von Ozon sowie eine Vorrichtung zur Ozongenerierung.

Ozon ist ein aus drei Sauerstoffatomen bestehendes Molekül O₃. Ozon ist bei Standardbedingungen gasförmig. Ozon ist ein starkes Oxidationsmittel.

Bekannte Ozongeneratoren beruhen auf dem Prinzip der Ozongenerierung durch eine Hochspannung, wobei die Hochspannung beispielsweise mittels elektromagnetischen Hochspannungstransformatoren erzeugt werden kann und an eine Elektrode geführt wird, an welcher durch eine Koronaentladung Ozon erzeugt wird.

Um Überschläge bei kleinen Abmessungen der Ozongeneratoren vermeiden zu können, ist es erforderlich, die Hochspannungstransformatoren in eine Isolationsschicht einzugießen, wodurch einer Miniaturisierung einer Vorrichtung, die die Ozongeneratoren aufweist, Grenzen gesetzt werden. Des Weiteren ist der Wirkungsgrad des Ozongenerators durch den Wirkungsgrad des elektromagnetischen Hochspannungstransformators begrenzt.

JP 2003 257589 A zeigt eine Vorrichtung, bei der Ozon mittels eines Hochspannungsgenerators 1a, der einen piezoelektrischen Transformator aufweist, erzeugt wird. Der piezoelektrische Transformtor ist in einem Gehäuse angeordnet und erzeugt eine Hochspannung, die an eine Entladeelektrode übertragen wird, welche außerhalb des Gehäuses angeordnet ist.

Aufgabe der vorliegenden Erfindung ist es nunmehr, ein verbessertes Verfahren zur Herstellung von Ozon sowie eine verbesserte Vorrichtung zur Ozongenerierung anzugeben. Diese Aufgaben werden durch das Verfahren gemäß dem vorliegenden Anspruch 1 sowie durch die Vorrichtung zur Ozongenerierung gemäß dem zweiten unabhängigen Anspruch gelöst.

Es wird ein Verfahren zur Herstellung von Ozon vorgeschlagen, wobei ein piezoelektrischer Transformator zur Generierung des Ozons verwendet wird. Das Ozon wird dabei durch die folgenden Schritte generiert:
- Anlegen einer Eingangsspannung an einen Eingangsbereich des piezoelektrischen Transformators, sodass in einem Ausgangsbereich des piezoelektrischen Transformators eine Hochspannung erzeugt wird, und
- Umgeben des piezoelektrischen Transformators mit einem sauerstoffhaltigen Prozessgas, wobei durch die im Ausgangsbereich erzeugte Hochspannung aus dem Prozessgas Ozon gebildet wird.

Die Verwendung eines piezoelektrischen Transformators zur Ozongenerierung bietet zahlreiche Vorteile. Der piezoelektrische Transformator kann insbesondere einen hohen Wirkungsgrad aufweisen, sodass das Ozon mit einem hohen Wirkungsgrad generiert werden kann. Der Wirkungsgrad kann dabei definiert sein durch die Menge an erzeugtem Ozon pro Wattstunde einer Eingangsleistung, die an den piezoelektrischen Transformator angelegt wird. Somit kann bei Verwendung eines piezoelektrischen Transformators für eine gewünschte Ozongenerierungsrate eine vergleichsweise geringe Eingangsleistung ausreichen.

Ferner kann der piezoelektrische Transformator eine gute Miniaturisierung einer Vorrichtung zur Ozongenerierung ermöglichen. Piezoelektrische Transformatoren lassen sich mit sehr geringen Abmessungen, beispielsweise mit Kantenlängen von wenigen Millimetern, fertigen. Beispielsweise kann der piezoelektrische Transformator eine Länge von weniger als 100 mm aufweisen, z.B. eine Länge von 70 mm oder von 45 mm.

Bei dem Verfahrensschritt "Umgeben des piezoelektrischen Transformators mit einem sauerstoffhaltigen Prozessgas" kann das Prozessgas mittels eines Ventilators oder einer anderen Vorrichtung dem piezoelektrischen Transformator zugeführt werden, sodass der Ausgangsbereich von dem Prozessgas umströmt wird. Alternativ kann der piezoelektrische Transformator in einer Umgebung angeordnet sein, deren Atmosphäre das Prozessgas enthält. Bei dem sauerstoffhaltigen Prozessgas kann es sich beispielsweise um Luft oder um reinen Sauerstoff handeln.

Ferner umfasst ein erstes erfindungsgemäßes Verfahren die Schritte
- Messens einer Menge des erzeugten Ozons mit einem Sensor sowie
- Anpassen der an den piezoelektrischen Transformator angelegten Eingangsspannung in Abhängigkeit von der gemessenen Menge des erzeugten Ozons zur Einstellung einer gewünschten Ozongenerierungsrate. Auf diese Weise kann es ermöglicht werden, ständig die an den piezoelektrischen Transformator angelegte Eingangsspannung anzupassen, sodass die vom piezoelektrischen Transformator erzeugte Menge des Ozons der gewünschten Ozongenerierungsrate entspricht. Dadurch wird eine automatische Dosierung des erzeugten Ozons ermöglicht.

In einem zweiten erfindungsgemäßen Verfahren wird der piezoelektrische Transformator gepulst betrieben. Bei einem gepulsten Betrieb des piezoelektrischen Transformators wechseln sich in regelmäßigen Abständen Phasen, in denen eine Eingangsspannung an den piezoelektrischen Transformator angelegt ist, und Phasen, in denen keine Eingangsspannung an den piezoelektrischen Transformator angelegt ist, ab. Dementsprechend kann der piezoelektrische Transformator abwechselnd für eine bestimmte Zeit eingeschaltet und für eine bestimmte Zeit ausgeschaltet sein. Durch eine Variation der Dauer der Phasen, in denen der Transformator eingeschaltet ist, und/oder durch eine Variation der Dauer der Phasen, in denen der Transformator ausgeschaltet ist, kann eine gewünschte mittlere Ozongenerierungsrate eingestellt werden.

Das erzeugte Ozon kann zur Beseitigung von Gerüchen in einer Umgebungsluft eingesetzt werden. Durch die oxidierende Wirkung des Ozons können Geruchsstoffe in einer Atmosphäre in geruchsneutrale Stoffe umgewandelt werden. Ebenso können Keime und geruchsverursachende Bakterien, auch an sonst unzugänglichen Stellen, abgetötet werden. Aus diesem Grund eignet sich Ozon beispielsweise zur Beseitigung von unerwünschten Gerüchen.

Das zweite erfindungsgemäß Verfahren dient zur Herstellung von Ozon, wobei ein piezoelektrischer Transformator zur Generierung des Ozons verwendet wird und wobei das Ozon durch folgende Schritte generiert wird:
- Anlegen einer Eingangsspannung an einen Eingangsbereich des piezoelektrischen Transformators, so dass in einem Ausgangsbereich des piezoelektrischen Transformators eine Hochspannung erzeugt wird, wobei der piezoelektrische Transformator gepulst betrieben wird,
- Umgeben des piezoelektrischen Transformators mit einem sauerstoffhaltigen Prozessgas, wobei durch die im Ausgangsbereich erzeugte Hochspannung aus dem Prozessgas Ozon gebildet wird.

Ein weiterer Aspekt der vorliegenden Erfindung betrifft eine Vorrichtung zur Ozongenerierung, die einen piezoelektrischen Transformator aufweist, der einen Eingangsbereich und einen Ausgangsbereich aufweist, wobei der Eingangsbereich dazu ausgestaltet ist, eine angelegte Wechselspannung in eine mechanische Schwingung zu wandeln, wobei der Ausgangsbereich dazu ausgestaltet ist, eine mechanische Schwingung in eine elektrische Spannung zu wandeln, sodass an dem Ausgangsbereich durch die erzeugte Spannung Ozon generierbar ist.

Wie oben bereits beschrieben, bietet die Verwendung eines piezoelektrischen Transformators in einer Vorrichtung zur Ozongenerierung die Vorteile eines hohen Wirkungsgrades sowie einer sehr guten Miniaturisierung.

Bei der Vorrichtung zur Ozongenerierung kann es sich um ein Handgerät handeln, das für einen mobilen Einsatz geeignet ist. Die Vorrichtung kann dementsprechend tragbar sein und kann von einem Nutzer stets an den gewünschten Einsatzort bewegt werden. Da die Länge der längsten Kante des piezoelektrischen Transformators kleiner als 100 mm sein kann und da der piezoelektrische Transformator ferner einen geringen Energiebedarf aufweist, der einen Betrieb mit einer Batterie ermöglicht, eignet er sich sehr gut für den Einsatz in einem Handgerät.

Die Vorrichtung weist ferner erfindungsgemäß ein Gehäuse auf, das zumindest eine Ozonaustrittsöffnung aufweist, wobei der piezoelektrische Transformator in dem Gehäuse angeordnet ist.

Vorzugsweise ist die Ozonaustrittsöffnung in unmittelbarer Nähe zu einer ausgangsseitigen Stirnseite des piezoelektrischen Transformators angeordnet, an der das Ozon generiert wird. Da es sich bei Ozon um ein langlebiges Molekül handelt, ist auch eine Anordnung der Ozonaustrittsöffnungen in einem gewissen Abstand von der ausgangsseitigen Stirnseite des piezoelektrischen Transformators denkbar, da nicht zu befürchten ist, dass das Ozon unmittelbar nach seiner Generierung zerfällt.

Durch die Anordnung und die Form der Ozonaustrittsöffnung kann das generierte Ozon gezielt einem Anwendungsbereich zugeführt werden. Dabei ist es denkbar, die Austrittsöffnung derart auszugestalten, dass das Ozon breit gefächert in einer Wolke aus der Vorrichtung heraustritt. Alternativ ist es auch möglich, die Ozonaustrittsöffnung derart auszugestalten, dass ein fokussierter Ozonstrahl aus der Vorrichtung austritt.

Bei einer ersten erfindungsgemäßen Vorrichtung sind in dem Gehäuse ein Sensor und eine Ansteuerschaltung angeordnet.

Die erste erfindungsgemäße Vorrichtung weist einen Sensor auf, der dazu ausgestaltet ist, eine Menge des generierten Ozons zu messen. Die von dem Sensor gemessenen Daten werden an eine Ansteuerschaltung des piezoelektrischen Transformators übermittelt. Der Sensor kann dazu ausgestaltet sein, die Menge des erzeugten Ozons in periodischen Raten zu ermitteln.

Ferner weist die Vorrichtung eine Ansteuerschaltung auf, die dazu ausgestaltet ist, eine Eingangsspannung an den piezoelektrischen Transformator anzulegen. Die Vorrichtung kann einen Schalter aufweisen, wobei die Ansteuerschaltung und der Schalter derart verbunden sind, dass die Eingangsspannung nur angelegt wird, solange der Schalter in einer gedrückten Position gehalten wird.

Bei dem Schalter kann es sich insbesondere um eine Taste handeln, die von einem Nutzer der Vorrichtung gedrückt werden kann. Der Schalter kann eine gedrückte Position und eine nicht-gedrückte Position aufweisen.

Wird, wie oben beschrieben, nur dann eine Eingangsspannung angelegt, wenn der Schalter in der gedrückten Position gehalten wird, so kann auf diese Weise die Sicherheit der Vorrichtung zur Ozongenerierung erhöht werden. Da es sich bei Ozon um einen potentiell gesundheitsschädlichen Stoff handelt, sollte die Vorrichtung derart ausgestaltet sein, dass Ozon nur dann generiert wird, wenn es tatsächlich erforderlich ist. Dadurch, dass der Schalter dauerhaft gedrückt bleiben muss, um die Ozongenerierung aufrechtzuerhalten, kann sichergestellt werden, dass die Vorrichtung nicht versehentlich eingeschaltet bleibt.

In einer alternativen Ausgestaltung kann die Ansteuerschaltung mit dem Schalter derart verbunden sein, dass ein einmaliges Drücken des Schalters das Anlegen der Eingangsspannung auslöst und ein weiteres Drücken des Schalters eine Versorgung des piezoelektrischen Transformators mit der Eingangsspannung trennt.

Die Vorrichtung kann eine integrierte Spannungsversorgung aufweisen. Dabei kann es sich um einen Akku oder eine austauschbare Batterie handeln. Ferner kann die Vorrichtung einen Anschluss für eine externe Spannungsversorgung aufweisen. Insbesondere bei der Verwendung der Vorrichtung als Handgerät ist eine integrierte Spannungsversorgung vorteilhaft, da in diesem Fall auf ein Kabel für den Anschluss einer externen Spannungsversorgung verzichtet werden kann.

Die Vorrichtung kann derart ausgestaltet sein, dass die integrierte Spannungsversorgung mittels einem induktiven Ladevorgang aufladbar ist. Dementsprechend kann auf Anschlüsse, an denen ein Ladegerät angeschlossen werden müsste, verzichtet werden. Durch die Verwendung des induktiven Ladevorgangs wird es ermöglicht, ein besonders dichtes Gehäuse zu verwenden, das sicherstellen kann, dass die Vorrichtung - und damit der piezoelektrische Transformator - gegen Beschädigungen durch äußere Einflüsse, beispielsweise Schmutz oder Feuchtigkeit, gut geschützt werden können.

Im Folgenden wird die vorliegende Erfindung anhand der Figuren näher erläutert.
- Figur 1: zeigt einen piezoelektrischen Transformator, der in einer erfindungsgemäßen Vorrichtung zur Ozongenerierung verwendet werden kann, in einer perspektivischen Ansicht,

- Figur 2: zeigt eine Vorrichtung zur Ozongenerierung gemäß einem ersten Ausführungsbeispiel,
- Figur 3: zeigt eine Vorrichtung zur Ozongenerierung gemäß einem zweiten Ausführungsbeispiel,
- Figur 4: zeigt einen Ausschnitt einer Vorrichtung zur Ozongenerierung.

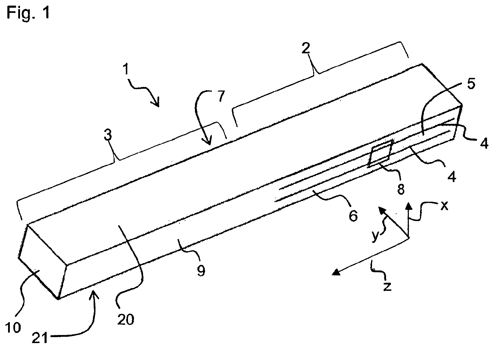

Figur 1 zeigt einen piezoelektrischen Transformator 1, der in einer erfindungsgemäßen Vorrichtung zur Ozongenerierung verwendet werden kann, in einer perspektivischen Ansicht. Der piezoelektrische Transformator 1 kann insbesondere in einer Vorrichtung zur Ozongenerierung eingesetzt werden.

Ein piezoelektrischer Transformator 1 ist eine Bauform eines Resonanztransformators, welcher auf Piezoelektrizität basiert und im Gegensatz zu den herkömmlichen magnetischen Transformatoren ein elektromechanisches System darstellt. Der piezoelektrische Transformator 1 ist beispielsweise ein Transformator vom Rosen-Typ.

Der piezoelektrische Transformator 1 weist einen Eingangsbereich 2 und einen Ausgangsbereich 3 auf, wobei der Ausgangsbereich 3 sich in einer longitudinalen Richtung z an den Eingangsbereich 2 anschließt. Im Eingangsbereich 2 weist der piezoelektrische Transformator 1 Elektroden 4 auf, an die eine Wechselspannung angelegt werden kann. Die Elektroden 4 erstrecken sich in der longitudinalen Richtung z des piezoelektrischen Transformators 1. Die Elektroden 4 sind in einer Stapelrichtung x, die senkrecht zu der longitudinalen Richtung z ist, abwechselnd mit einem piezoelektrischen Material 5 gestapelt. Das piezoelektrische Material 5 ist dabei in Stapelrichtung x polarisiert.

Die Elektroden 4 sind im Innern des piezoelektrischen Transformators 1 angeordnet und werden auch als Innenelektroden bezeichnet. Der piezoelektrische Transformator 1 weist eine erste Seitenfläche 6 und eine zweite Seitenfläche 7, die der ersten Seitenfläche 6 gegenüberliegt, auf. Auf der ersten Seitenfläche 6 ist eine erste Außenelektrode 8 angeordnet. Auf der zweiten Seitenfläche 7 ist eine zweite Außenelektrode (nicht gezeigt) angeordnet. Die innenliegenden Elektroden 4 sind in Stapelrichtung x abwechselnd entweder mit der ersten Außenelektrode 8 oder der zweiten Außenelektrode elektrisch kontaktiert.

Ferner weist der piezoelektrische Transformator 1 eine dritte Seitenfläche 20 und eine vierte Seitenfläche 21 auf, die einander gegenüberliegen und die senkrecht zu der ersten Seitenfläche 6 und der zweiten Seitenfläche 7 angeordnet sind. Die Flächennormalen der dritten und der vierten Seitenflächen 20, 21 zeigen jeweils in Stapelrichtung x.

Der Eingangsbereich 2 kann mit einer geringen Wechselspannung angesteuert werden, die zwischen den Elektroden 4 angelegt wird. Aufgrund des piezoelektrischen Effekts wird die eingangsseitig angelegte Wechselspannung zunächst in eine mechanische Schwingung umgewandelt. Die Frequenz der mechanischen Schwingung ist dabei wesentlich von der Geometrie und dem mechanischen Aufbau des piezoelektrischen Transformators 1 abhängig.

Der Ausgangsbereich 3 weist piezoelektrisches Material 9 auf und ist frei von innenliegenden Elektroden. Das piezoelektrische Material 9 im Ausgangsbereich ist in der longitudinalen Richtung z polarisiert. Bei dem piezoelektrischen Material 9 des Ausgangsbereichs 3 kann es sich um das gleiche Material wie bei dem piezoelektrischen Material 5 des Eingangsbereichs 2 handeln, wobei sich die piezoelektrischen Materialien 5 und 9 in ihrer Polarisationsrichtung unterscheiden können. Im Ausgangsbereich 3 ist das piezoelektrische Material 9 zu einer einzigen monolithischen Schicht geformt, die vollständig in der longitudinalen Richtung z polarisiert ist. Dabei weist das piezoelektrische Material 9 im Ausgangsbereich 3 nur eine einzige Polarisationsrichtung auf.

Wird an die Elektroden 4 im Eingangsbereich 2 eine Wechselspannung angelegt, so bildet sich innerhalb des piezoelektrischen Materials 5, 9 eine mechanische Welle aus, die durch den piezoelektrischen Effekt im Ausgangsbereich 3 eine Ausgangsspannung erzeugt. Der Ausgangsbereich 3 weist eine ausgangsseitige Stirnseite 10 auf. Im Ausgangsbereich 3 wird somit eine elektrische Spannung zwischen der Stirnseite 10 und dem Ende der Elektroden 4 des Eingangsbereichs 2 erzeugt. An der ausgangsseitigen Stirnseite 10 wird dabei eine Hochspannung erzeugt. Dabei entsteht auch zwischen der ausgangseitigen Stirnseite und einer Umgebung des piezoelektrischen Transformators eine hohe Potentialdifferenz, die ausreicht, um ein starkes elektrisches Feld zu erzeugen, dass ein sauerstoffhaltiges Prozessgas derart ionisiert, dass Ozon gebildet wird. Dabei werden Atome oder Moleküle des sauerstoffhaltigen Prozessgases ionisiert und bilden Ozon.

Bei dem sauerstoffhaltigen Prozessgas kann es sich insbesondere um Luft oder um reinen Saurestoff handeln.

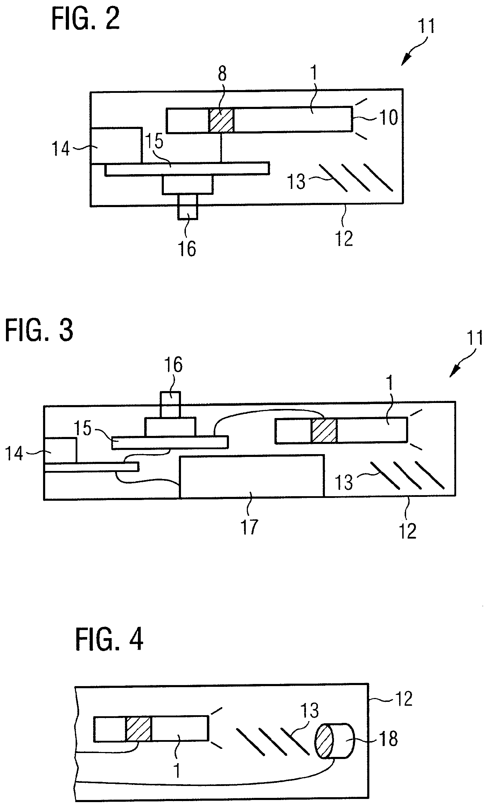

Figur 2 zeigt ein erstes Ausführungsbeispiel einer Vorrichtung zur Ozongenerierung 11. Die Vorrichtung 11 weist den piezoelektrischen Transformator 1 auf. Ferner weist die Vorrichtung 11 ein Gehäuse 12 auf, in dem der piezoelektrische Transformator 1 angeordnet ist. Das Gehäuse 12 weist Ozonaustrittsöffnungen 13 auf, aus denen das von dem piezoelektrischen Transformator 1 erzeugte Ozon aus der Vorrichtung 11 austreten kann. Die Ozonaustrittsöffnungen 13 sind schlitzförmig. Die Ozonaustrittsöffnungen 13 sind in der Nähe des Ausgangsbereichs 3 des piezoelektrischen Transformators 1 angeordnet.

Neben dem piezoelektrischen Transformator 1 sind weitere Elemente in dem Gehäuse 12 angeordnet, insbesondere eine Leiterplatine 15 auf, auf der eine Ansteuerschaltung realisiert sein kann, und ein Anschluss 14 für eine externe Spannungsversorgung. Ferner kann auch eine Spannungsversorgung 17 in das Gehäuse integriert sein. Diese weiteren Elemente sind nicht von eigenen, separaten Gehäusen umgeben.

Ferner weist die Vorrichtung zur Ozongenerierung einen Anschluss 14 für eine externe Spannungsversorgung auf. An diesen Anschluss 14 kann beispielsweise ein Netzgerät angeschlossen werden.

Die Vorrichtung 11 zur Ozongenerierung weist ferner eine Leiterplatine 15 auf, auf der eine Ansteuerschaltung realisiert sein kann. Die Ansteuerschaltung ist dazu ausgestaltet, an den Eingangsbereich 2 des piezoelektrischen Transformators 1 eine Eingangsspannung anzulegen. Bei der Eingangsspannung handelt es sich um eine Wechselspannung. Der piezoelektrische Transformator 1 wird dabei gepulst betrieben. Bei einem gepulsten Betrieb wird die Eingangsspannung für eine erste vorbestimmte Zeitspanne angelegt und anschließend für eine zweite vorbestimmte Zeitspanne nicht angelegt. Diese beiden Zeitspannen wechseln sich periodisch ab. Die Ozongenerierungsrate der Vorrichtung 11 kann auf einen gewünschten Wert eingestellt werden, indem eine Eingangsspannung, die an dem piezoelektrischen Transformator 1 angelegt wird, variiert wird und/oder indem bei einem gepulsten Betrieb die beiden Zeitspannen variiert werden.

Die Vorrichtung 11 zur Ozongenerierung weist ferner einen Schalter 16 auf, der mit der Leiterplatine 15 verbunden ist. In einem ersten Ausführungsbeispiel wird eine Eingangsspannung an den piezoelektrischen Transformator 1 nur dann angelegt, wenn der Schalter 16 sich in einer gedrückten Position befindet. Wird von einem Nutzer kein Druck auf den Schalter 16 ausgeübt, so bewegt sich der Schalter 16 stets aus seiner gedrückten Position in eine nicht-gedrückte Position. Dementsprechend wird nur solange von der Vorrichtung 11 Ozon generiert, wie ein Nutzer den Schalter 16 in der gedrückten Position hält.

In einem alternativen Ausführungsbeispiel kann der Schalter 16 mit der Leiterplatine 15 derart verschaltet sein, dass ein erstmaliges Drücken des Schalters 16 das Anlegen der Eingangsspannung an den piezoelektrischen Transformator 1 auslöst. Die Ansteuerschaltung wird nunmehr solange eine Eingangsspannung an den piezoelektrischen Transformator 1 anlegen, bis ein Nutzer durch ein weiteres Drücken des Schalters 16 signalisiert, dass nunmehr der piezoelektrische Transformator 1 ausgeschaltet werden soll. Dementsprechend wird bei einem zweiten Drücken des Schalters 16 die Spannungsversorgung des piezoelektrischen Transformators 1 mit der Eingangsspannung unterbrochen.

Figur 3 zeigt ein zweites Ausführungsbeispiel der Vorrichtung 11 zur Ozongenerierung. Gemäß dem zweiten Ausführungsbeispiel weist die Vorrichtung 11 zur Ozongenerierung ferner eine integrierte Spannungsversorgung 17 auf. Bei der integrierten Spannungsversorgung 17 kann es sich beispielsweise um einen Akku oder um eine austauschbare Batterie handeln. Gemäß dem in Figur 3 gezeigten Ausführungsbeispiel ist die integrierte Spannungsversorgung 17 zusätzlich zu dem Anschluss 14 für die externe Spannungsversorgung vorgesehen. Alternativ könnte die integrierte Spannungsversorgung 17 auch als einzige Spannungsquelle der Vorrichtung 11 zur Ozongenerierung vorgesehen sein. Dabei würde die Vorrichtung 11 keinen Anschluss 14 für eine externe Spannungsversorgung aufweisen.

Figur 4 zeigt einen vergrößerten Ausschnitt einer Vorrichtung 11 zur Ozongenerierung gemäß einem weiteren Ausführungsbeispiel auf. Die Vorrichtung weist zusätzlich zu den in Figur 2 und Figur 3 gezeigten Vorrichtungen 11 einen Sensor 18 auf, der dazu ausgestaltet ist, die Menge des aktuell von dem piezoelektrischen Transformator 1 generierten Ozons zu messen. Durch die Erfassung der Menge des geneierten Ozons wird es ermöglicht, die Ozongenerierung auf eine gewünschte Ozongenerierungsrate einzustellen. Dabei kann der Sensor 18 mit der Ansteuerplatine rückgekoppelt sein.

Dementsprechend kann die Ansteuerschaltung die an den piezoelektrischen Transformator 1 angelegte Eingangsspannung und/oder die Dauer der Pulse bei gepulstem Betrieb in gewünschter Weise anpassen, um eine gewünschte Ozongenerierungsrate einzustellen.

### Bezugszeichenliste

- 1: piezoelektrischer Transformator
- 2: Eingangsbereich
- 3: Ausgangsbereich
- 4: Elektrode
- 5: piezoelektrisches Material
- 6: erste Seitenfläche
- 7: zweite Seitenfläche
- 8: erste Außenelektrode
- 9: piezoelektrisches Material
- 10: ausgangsseitige Stirnseite
- 11: Vorrichtung zur Ozongenerierung
- 12: Gehäuse
- 13: Ozonaustrittsöffnung
- 14: Anschluss für eine externe Spannungsversorgung
- 15: Leiterplatine
- 16: Schalter
- 17: integrierte Spannungsversorgung
- 18: Sensor
- 20: dritte Seitenfläche
- 21: vierte Seitenfläche

- x: Stapelrichtung
- Z: longitudinalen Richtung

## Patentansprüche

1. Verfahren zur Herstellung von Ozon,
wobei ein piezoelektrischer Transformator (1) zur Generierung des Ozons verwendet wird und wobei das Ozon durch folgende Schritte generiert wird:
- Anlegen einer Eingangsspannung an einen Eingangsbereich (2) des piezoelektrischen Transformators (1), so dass in einem Ausgangsbereich (3) des piezoelektrischen Transformators (1) eine Hochspannung erzeugt wird,
- Umgeben des piezoelektrischen Transformators (1) mit einem sauerstoffhaltigen Prozessgas, wobei durch die im Ausgangsbereich (3) erzeugte Hochspannung aus dem Prozessgas Ozon gebildet wird,
- Messen der Menge des erzeugten Ozon mit einem Sensor (18), und
- Anpassen der an den piezoelektrischen Transformator (1) angelegten Eingangsspannung in Abhängigkeit von der gemessenen Menge des erzeugten Ozons zur Einstellung einer gewünschten Ozongenerierungsrate.

2. Verfahren gemäß dem vorherigen Anspruch,
wobei der piezoelektrische Transformator (1) gepulst betrieben wird.

3. Verfahren gemäß einem der vorherigen Ansprüche,
wobei das erzeugte Ozon zur Beseitigung von Gerüchen in einer Umgebungsluft eingesetzt wird.

4. Verfahren zur Herstellung von Ozon,
wobei ein piezoelektrischer Transformator (1) zur Generierung des Ozons verwendet wird und wobei das Ozon durch folgende Schritte generiert wird:
- Anlegen einer Eingangsspannung an einen Eingangsbereich (2) des piezoelektrischen Transformators (1), so dass in einem Ausgangsbereich (3) des piezoelektrischen Transformators (1) eine Hochspannung erzeugt wird, wobei der piezoelektrische Transformator (1) gepulst betrieben wird, wobei sich bei dem gepulsten Betrieb des piezoelektrischen Transformators (1) Phasen, in denen eine Eingangsspannung an den piezoelektrischen Transformator (1) angelegt ist, und Phasen, in denen keine Eingangsspannung an den piezoelektrischen Transformator (1) angelegt ist, in regelmäßigen Abständen abwechseln,
- Umgeben des piezoelektrischen Transformators (1) mit einem sauerstoffhaltigen Prozessgas, wobei durch die im Ausgangsbereich (3) erzeugte Hochspannung aus dem Prozessgas Ozon gebildet wird.

5. Vorrichtung (11) zur Ozongenerierung,
die einen piezoelektrischen Transformator (1) aufweist, der einen Eingangsbereich (2) und einen Ausgangsbereich (3) aufweist, wobei der Eingangsbereich (2) dazu ausgestaltet ist, eine angelegte Wechselspannung in eine mechanische Schwingung zu wandeln, wobei der Ausgangsbereich (3) dazu ausgestaltet ist, eine mechanische Schwingung in eine elektrische Spannung zu wandeln, so dass an dem Ausgangsbereich (3) durch die erzeugte elektrische Spannung Ozon generierbar ist, wobei der Ausgangsbereich (3) des piezoelektrischen Transformators (1) eine Stirnseite aufweist, an der das Ozon generiert wird,
wobei die Vorrichtung ein Gehäuse (12) aufweist, das zumindest eine Ozonaustrittsöffnung aufweist, wobei der piezoelektrische Transformator (1) in dem Gehäuse (12) angeordnet ist,
wobei die Vorrichtung (11) einen Sensor (18) und eine Ansteuerschaltung aufweist, wobei der Sensor (18) dazu ausgestaltet ist, eine Menge des generierten Ozons zu messen, wobei der Sensor (18) mit einer Ansteuerplatine rückgekoppelt ist, und wobei die Ansteuerschaltung dazu ausgestaltet ist, eine an den piezoelektrischen Transformator (1) angelegte Eingangsspannung in Abhängigkeit von der gemessenen Menge des erzeugten Ozons zur Einstellung einer gewünschten Ozongenerierungsrate anzupassen.

6. Vorrichtung (11) gemäß Anspruch 5,
wobei die Ansteuerschaltung dazu ausgestaltet ist, eine Eingangsspannung an den piezoelektrischen Transformator (1) anzulegen, und
wobei die Vorrichtung (11) einen Schalter (16) aufweist, wobei die Ansteuerschaltung und der Schalter (16) derart verbunden sind, dass die Eingangsspannung nur angelegt wird, solange der Schalter (16) in einer gedrückten Position gehalten wird.

7. Vorrichtung (11) gemäß Anspruch 5,
wobei die Ansteuerschaltung dazu ausgestaltet ist, eine Eingangsspannung an den piezoelektrischen Transformator (1) anzulegen, wobei die Vorrichtung (11) einen Schalter (16) aufweist, wobei die Ansteuerschaltung und der Schalter (16) derart verbunden sind, dass ein einmaliges Drücken des Schalters (16) das Anlegen der Eingangsspannung auslöst und ein weiteres Drücken des Schalters (16) eine Versorgung des piezoelektrischen Transformators (1) mit der Eingangsspannung trennt.

8. Vorrichtung (11) gemäß einem der Ansprüche 5 bis 7,
wobei die Vorrichtung (11) eine in das Gehäuse integrierte Spannungsversorgung (17) aufweist.

9. Vorrichtung (11) gemäß dem vorherigen Anspruch,
wobei die Vorrichtung (11) derart ausgestaltet ist, dass die integrierte Spannungsversorgung (17) mittels einem induktiven Ladevorgang aufladbar ist.

10. Vorrichtung (11) zur Ozongenerierung,
die einen piezoelektrischen Transformator (1) aufweist, der einen Eingangsbereich (2) und einen Ausgangsbereich (3) aufweist, wobei der Eingangsbereich (2) dazu ausgestaltet ist, eine angelegte Wechselspannung in eine mechanische Schwingung zu wandeln, wobei der Ausgangsbereich (3) dazu ausgestaltet ist, eine mechanische Schwingung in eine elektrische Spannung zu wandeln, so dass an dem Ausgangsbereich (3) durch die erzeugte elektrische Spannung Ozon generierbar ist, wobei der Ausgangsbereich (3) des piezoelektrischen Transformators (1) eine Stirnseite aufweist, an der das Ozon generiert wird,
wobei die Vorrichtung ein Gehäuse (12) aufweist, das zumindest eine Ozonaustrittsöffnung aufweist, wobei der piezoelektrische Transformator (1) in dem Gehäuse (12) angeordnet ist,
wobei die Vorrichtung dazu ausgestaltet ist, den piezoelektrischen Transformator (1) gepulst zu betreiben, wobei sich bei dem gepulsten Betrieb Phasen, in denen eine Eingangsspannung an den piezoelektrischen Transformator (1) angelegt ist, und Phasen, in denen keine Eingangsspannung an den piezoelektrischen Transformator (1) angelegt ist, in regelmäßigen Abständen abwechseln.

## Claims

1. Process for producing ozone,
wherein a piezoelectric transformer (1) is used to generate the ozone, and wherein the ozone is generated by means of the following steps:
- applying an input voltage to an input area (2) of the piezoelectric transformer (1), with the result that a high voltage is generated in an output area (3) of the piezoelectric transformer (1),
- surrounding the piezoelectric transformer (1) with an oxygenic process gas, wherein ozone is formed from the process gas by means of the high voltage generated in the output area (3),
- measuring the amount of generated ozone using a sensor (18), and
- adapting the input voltage applied to the piezoelectric transformer (1) on the basis of the measured amount of generated ozone in order to set a desired ozone generation rate.

2. Process according to the preceding claim,
wherein the piezoelectric transformer (1) is operated in a pulsed manner.

3. Process according to either of the preceding claims, wherein the generated ozone is used to eliminate odours in ambient air.

4. Process for producing ozone,
wherein a piezoelectric transformer (1) is used to generate the ozone, and wherein the ozone is generated by means of the following steps:
- applying an input voltage to an input area (2) of the piezoelectric transformer (1), with the result that a high voltage is generated in an output area (3) of the piezoelectric transformer (1), wherein the piezoelectric transformer (1) is operated in a pulsed manner, wherein, during pulsed operation of the piezoelectric transformer (1), phases in which an input voltage is applied to the piezoelectric transformer (1) and phases in which an input voltage is not applied to the piezoelectric transformer (1) alternate at regular intervals,
- surrounding the piezoelectric transformer (1) with an oxygenic process gas, wherein ozone is formed from the process gas by means of the high voltage generated in the output area (3).

5. Apparatus (11) for generating ozone,
which has a piezoelectric transformer (1) having an input area (2) and an output area (3), wherein the input area (2) is configured to convert an applied AC voltage into a mechanical vibration, wherein the output area (3) is configured to convert a mechanical vibration into a voltage, with the result that ozone is able to be generated by means of the generated voltage in the output area (3),
wherein the output area (3) of the piezoelectric transformer (1) has an end face at which the ozone is generated,
wherein the apparatus has a housing (12), which has at least one ozone outlet opening, wherein the piezoelectric transformer (1) is arranged in the housing (12),
wherein the apparatus (11) has a sensor (18) and a control circuit, wherein the sensor (18) is configured to measure an amount of generated ozone, wherein the sensor (18) is coupled to a control board with feedback, and wherein the control circuit is configured to adapt an input voltage applied to the piezoelectric transformer (1) on the basis of the measured amount of generated ozone in order to set a desired ozone generation rate.

6. Apparatus (11) according to Claim 5,
wherein the control circuit is configured to apply an input voltage to the piezoelectric transformer (1), and wherein the apparatus (11) has a switch (16), wherein the control circuit and the switch (16) are connected in such a manner that the input voltage is applied only as long as the switch (16) is held in a pressed position.

7. Apparatus (11) according to Claim 5,
wherein the control circuit is configured to apply an input voltage to the piezoelectric transformer (1), wherein the apparatus (11) has a switch (16), wherein the control circuit and the switch (16) are connected in such a manner that pressing the switch (16) once triggers the application of the input voltage and further pressing of the switch (16) disconnects a supply of the piezoelectric transformer (1) with the input voltage.

8. Apparatus (11) according to one of Claims 5 to 7, wherein the apparatus (11) has a voltage supply (17) integrated into the housing.

9. Apparatus (11) according to the preceding claim, wherein the apparatus (11) is configured in such a manner that the integrated voltage supply (17) is able to be charged by means of an inductive charging operation.

10. Apparatus (11) for generating ozone,
which has a piezoelectric transformer (1) having an input area (2) and an output area (3), wherein the input area (2) is configured to convert an applied AC voltage into a mechanical vibration, wherein the output area (3) is configured to convert a mechanical vibration into a voltage, with the result that ozone is able to be generated by means of the generated voltage in the output area (3),
wherein the output area (3) of the piezoelectric transformer (1) has an end face at which the ozone is generated,
wherein the apparatus has a housing (12), which has at least one ozone outlet opening, wherein the piezoelectric transformer (1) is arranged in the housing (12),
wherein the apparatus is configured to operate the piezoelectric transformer (1) in a pulsed manner, wherein, during pulsed operation, phases in which an input voltage is applied to the piezoelectric transformer (1) and phases in which an input voltage is not applied to the piezoelectric transformer (1) alternate at regular intervals.

## Revendications

1. Procédé de production d'ozone,
dans lequel un transformateur piézoélectrique (1) est utilisé pour générer l'ozone, et dans lequel l'ozone est générée par les étapes suivantes consistant à :
- appliquer une tension d'entrée à une zone d'entrée (2) du transformateur piézoélectrique (1) de façon à produire une haute tension dans une zone de sortie (3) du transformateur piézoélectrique (1),
- entourer le transformateur piézoélectrique (1) d'un gaz de processus oxygéné, dans lequel la haute tension produite dans la zone de sortie (3) permet de former de l'ozone à partir du gaz de processus,
- mesurer la quantité de l'ozone produite à l'aide d'un capteur (18), et
- adapter la tension d'entrée appliquée au transformateur piézoélectrique (1) en fonction de la quantité mesurée de l'ozone produite pour régler un taux de génération d'ozone souhaité.

2. Procédé selon la revendication précédente,
dans lequel le transformateur piézoélectrique (1) fonctionne en mode pulsé.

3. Procédé selon l'une quelconque des revendications précédentes,
dans lequel l'ozone produite est mise en œuvre pour éliminer des odeurs dans l'air ambiant.

4. Procédé de production d'ozone,
dans lequel un transformateur piézoélectrique (1) est utilisé pour générer l'ozone, et dans lequel l'ozone est générée par les étapes suivantes consistant à :
- appliquer une tension d'entrée à une zone d'entrée (2) du transformateur piézoélectrique (1) de façon à produire une haute tension dans une zone de sortie (3) du transformateur piézoélectrique (1), le transformateur piézoélectrique (1) fonctionnant en mode pulsé, dans lequel, lors du fonctionnement pulsé du transformateur piézoélectrique (1), des phases dans lesquelles une tension d'entrée est appliquée au transformateur piézoélectrique (1) et des phases dans lesquelles aucune tension d'entrée n'est appliquée au transformateur piézoélectrique (1) alternent à intervalles réguliers,
- entourer le transformateur piézoélectrique (1) d'un gaz de processus oxygéné, dans lequel la haute tension produite dans la zone de sortie (3) permet de former de l'ozone à partir du gaz de processus.

5. Dispositif (11) de génération d'ozone,
qui présente un transformateur piézoélectrique (1) qui présente une zone d'entrée (2) et une zone de sortie (3), dans lequel la zone d'entrée (2) est configurée pour convertir une tension alternative appliquée en une oscillation mécanique, dans lequel la zone de sortie (3) est configurée pour convertir une oscillation mécanique en une tension électrique de sorte que de l'ozone peut être générée au niveau de la zone de sortie (3) par la tension électrique produite,
dans lequel la zone de sortie (3) du transformateur piézoélectrique (1) présente une face frontale sur laquelle l'ozone est générée,
dans lequel le dispositif présente un boîtier (12) qui présente au moins une ouverture de sortie d'ozone, dans lequel le transformateur piézoélectrique (1) est disposé dans le boîtier (12),
dans lequel le dispositif (11) présente un capteur (18) et un circuit de pilotage, le capteur (18) étant configuré pour mesurer une quantité de l'ozone générée, le capteur (18) étant couplé par réaction à une platine de pilotage, et dans lequel le circuit de pilotage est configuré pour adapter la tension d'entrée appliquée au transformateur piézoélectrique (1) en fonction de la quantité mesurée de l'ozone produite pour régler un taux de génération d'ozone souhaité.

6. Dispositif (11) selon la revendication 5,
dans lequel le circuit de pilotage est configuré pour appliquer une tension d'entrée au transformateur piézoélectrique (1), et
dans lequel le dispositif (11) présente un commutateur (16), dans lequel le circuit de pilotage et le commutateur (16) sont reliés de telle sorte que la tension d'entrée n'est appliquée que tant que le commutateur (16) est maintenu dans une position enfoncée.

7. Dispositif (11) selon la revendication 5,
dans lequel le circuit de pilotage est configuré pour appliquer une tension d'entrée au transformateur piézoélectrique (1), le dispositif (11) présentant un commutateur (16), dans lequel le circuit de pilotage et le commutateur (16) sont reliés de telle sorte qu'une pression unique du commutateur (16) déclenche l'application de la tension d'entrée et une pression supplémentaire du commutateur (16) déconnecte une alimentation du transformateur piézoélectrique (1) par la tension d'entrée.

8. Dispositif (11) selon l'une quelconque des revendications 5 à 7,
dans lequel le dispositif (11) présente une alimentation en tension (17) intégrée dans le boîtier.

9. Dispositif (11) selon la revendication précédente, dans lequel le dispositif (11) est configuré de telle sorte que l'alimentation en tension intégrée (17) peut être rechargée au moyen d'un processus de charge par induction.

10. Dispositif (11) de génération d'ozone,
qui présente un transformateur piézoélectrique (1) qui présente une zone d'entrée (2) et une zone de sortie (3), dans lequel la zone d'entrée (2) est configurée pour convertir une tension alternative appliquée en une oscillation mécanique, dans lequel la zone de sortie (3) est configurée pour convertir une oscillation mécanique en une tension électrique de sorte que de l'ozone peut être générée au niveau de la zone de sortie (3) par la tension électrique produite,
dans lequel la zone de sortie (3) du transformateur piézoélectrique (1) présente une face frontale sur laquelle l'ozone est générée,
dans lequel le dispositif présente un boîtier (12) qui présente au moins une ouverture de sortie d'ozone, dans lequel le transformateur piézoélectrique (1) est disposé dans le boîtier (12),
dans lequel le dispositif est configuré pour faire fonctionner le transformateur piézoélectrique (1) en mode pulsé, dans lequel, lors du fonctionnement pulsé, des phases dans lesquelles une tension d'entrée est appliquée au transformateur piézoélectrique (1) et des phases dans lesquelles aucune tension d'entrée n'est appliquée au transformateur piézoélectrique (1) alternent à intervalles réguliers.
